# EUROPÄISCHE PATENTSCHRIFT

(11) **EP 3 231 036 B1**
(45) Veröffentlichungstag und Bekanntmachung des Hinweises auf die Patenterteilung: **05.01.2022**
(21) Anmeldenummer: 15797686.1
(22) Anmeldetag: 23.11.2015
(51) Int. Cl.: H01Q 1/32, H01Q 9/32, H01Q 5/335, H01Q 5/50, H03H 7/38

(54) **KURZSTAB-MONOPOLANTENNE FÜR DEN EINSATZ IM MOBILEN BEREICH**
BENDABLE MONOPOLE ANTENNA FOR USE IN MOBILE ENVIRONMENTS
ANTENNE BÂTON MONOPÔLE POUR UNE MISE EN OEUVRE DANS LE DOMAINE MOBILE

(30) Priorität: 12.12.2014 DE 202014009872 U; 11.03.2015 DE 202015001905 U
(43) Veröffentlichungstag der Anmeldung: 18.10.2017
(73) Patentinhaber: Antennentechnik Bad Blankenburg GmbH, 99428 Weimar OT Legefeld (DE)
(72) Erfinder: BULBIN, Yuri, 07407 Rudolstadt (DE)
(74) Vertreter: Kruspig, Volkmar
(86) Internationale Anmeldenummer: PCT/EP2015/077312
(87) Internationale Veröffentlichungsnummer: WO 2016/091559

(56) Entgegenhaltungen:
- DE-U1-202014 002 207
- US-A1- 2009 278 748
- Aurora Aurora Andujar Andujar ET AL: "A systematic method to design broadband matching networks", Proceedings of the Fourth European Conference on Antennas and Propagation, 1 January 2010 (2010-01-01), pages 1-5, XP055177295, ISBN: 978-1-42-446431-9

## Beschreibung

Die Erfindung betrifft eine Kurzstab-Monopolantenne für den Einsatz im mobilen Bereich, bestehend aus einem Strahler, einem Antennenfuß, einem Antennengehäuse, welches dazu ausgebildet ist, elektrische und/oder elektronische Komponenten aufzunehmen, sowie einem am Antennengehäuse oder Antennenfuß vorgesehenen Antennenausgang gemäß dem Anspruch 1.

Kurzstab-Monopolantennen, auch ausgebildet als Mehrbereichsantennen für eine Empfangs- und/oder Sendeeinrichtung für den mobilen Einsatz, insbesondere Kraftfahrzeuge, gehören zum Stand der Technik.

Beispielsweise zeigt die DE 20 2014 002 207 U1 eine Mehrbereichsantenne für eine Empfangs- und/oder Sendeeinrichtung für den mobilen Einsatz. Die vorbekannte Antenne besteht aus einer isolierenden Trägerplatte zur Aufnahme von elektrischen Anschlusselementen sowie zur Antennenmontage, wobei auf der Trägerplatte, sich von dieser im Wesentlichen senkrecht erstreckend, eine kupferkaschierte Leiterplatte angeordnet ist. Die bekannte Antenne umfasst weiterhin ein haubenartiges Gehäuse aus dielektrischem Material.

Bei der Antenne nach DE 20 2014 002 207 U1 besteht die Möglichkeit der Ankopplung eines CB-Stabes, d.h. eines Strahlers für den zivilen Funkbetrieb, und zwar ohne dass der Einsatz von Sperrkreisen erforderlich wird.

Die Antenne ist so ausgebildet, dass die Möglichkeit gegeben ist, wahlweise einen CB-Strahler anzukoppeln, und zwar ohne Verschlechterung der übrigen Empfangsfrequenzbereiche. Es ist also bei der erwähnten Lösung der wahlweise Einsatz als CB- und/oder GSM Antenne möglich.

Das Antennengehäuse wird mit Blick auf den bevorzugten Einsatz bei Kraftfahrzeugen in einer strömungsoptimierten Form realisiert, d.h. das Gehäuse besitzt z.B. die Gestalt einer sogenannten Haifischflosse (shark design).

Bei der bekannten Antenne ist die CB-Antenne (citizen band) als Stabstrahler ausgeführt. Die Anschlussleitung, d.h. die Anschlussstruktur für den CB-Stab, befindet sich auf einer bezogen auf die GSM-Strahler gemeinsamen Leiterplatte.

Für den wahlweisen CB-Betrieb kann der Stabstrahler am haubenartigen Gehäuse z.B. durch Schrauben, Stecken, mittels Bajonett-Verschluss oder Ähnlichem befestigt werden. Insofern ist an der Oberseite des haubenartigen Gehäuses eine entsprechende Aufnahme für den Stabstrahler vorhanden.

Der Stabstrahler weist an seinem Strahlerende Abstimmmittel, z.B. einen Abstimmstub oder ein verlänger- bzw. verkürzbares Strahlerende auf.

Bei CB-Stabantennen für den mobilen Einsatz besteht eine Beschränkung der maximalen Strahlerlänge. Bei Nutzfahrzeugen und Lastkraftwagen darf eine maximale Fahrzeughöhe durch die Antenne nicht überschritten werden. Auch bei Personenkraftwagen behindert ein zu langer Stabstrahler den Umgang mit dem Fahrzeug, z.B. beim Einparken in einer Tiefgarage. Bekannte Kurzstab-CB-Antennen können 40 internationale bzw. 80 Kanäle bandbreitenseitig nicht verarbeiten. Aus diesem Grund besteht bisher die Notwendigkeit, CB-Stabantennen abstimmbar auszugestalten, was jedoch zu einem erhöhten Aufwand führt, der sich sowohl herstellerseitig als auch beim Einsatz und der Bedienung einer solchen Antenne nachteilig niederschlägt.

Aus der DE 295 13 911 U1 ist eine Kraftfahrzeug-Stabantenne vorbekannt, die zum Empfang unterschiedlicher Frequenzen, z.B. im Rundfunkbereich und gleichzeitig für den Mobilfunk ausgelegt ist. Um die Anpassung für den Funkbetrieb mit möglichst geringem Aufwand unter Beibehaltung des Antennenaufbaus zu verbessern und die Bandbreite der Antenne für den relevanten Bereich zu erhöhen, wird gemäß der DE 295 13 911 U1 die Erkenntnis genutzt, Schwingkreise aus Abschnitten der Spulenstruktur der Antenne und aus dazu achsparallelen oder koaxialen Leiterabschnitten zu bilden, so dass es gelingt, den Verlauf der Rückflussdämpfung für den Strahlerabschnitt für den höheren Frequenzbereich wirkungsvoll zu beeinflussen. Die entsprechenden Schwingkreise sind in Reihen, aber auch in Parallelschaltung vorgesehen, je nachdem, ob die kapazitiven Komponenten, d.h. die jeweiligen separaten Leiterabschnitte, dem Antennenleiter in achsparalleler Reihung oder quasi nebeneinander, auf gleicher Höhe, zugeordnet sind. Die Schwingkreisanordnungen bilden nach der dortigen Lehre mehrkreisige Bandpassfilter mit bandbreitenerhöhender Wirkung. Konkret wird zusätzlich zu dem Parallelschwingkreis, der für ein bestimmtes Frequenzband als Sperrkreis wirkt, in Parallel- oder in Serienschaltung ein weiterer Parallelschwingkreis angeordnet oder es werden zusätzlich ein in Serie und ein parallel geschalteter Parallelschwingkreis vorgesehen derart, dass mit Hilfe des oder der zusätzlichen L-C-Glieder breitbandig eine hohe Anpassung für den Strahler des betreffenden Frequenzbandes erzielbar ist. Alle L-C-Glieder nach der DE 295 13 911 U1 werden dadurch gebildet, dass dem Antennenleiter jeweils ein separater kurzer Leiterabschnitt koaxial oder achsparallel zugeordnet wird, wobei der gewendelte Antennenleiter als Induktivität und der zusätzliche separate Leiterabschnitt als Kapazität des Schwingkreises wirken.

Nachteilig bei der vorbekannten Lehre nach DE 295 13 911 U1 ist die Tatsache, dass zur Realisierung der L-C-Schwingkreise Elemente der Antenne, respektive des Strahlers selbst entsprechend verändert und ausgebildet werden müssen.

Aus Aurora Andüjar, Jaume Anguera, Carles Puente: "A systematic method to design broadband matching networks", Proceedings of the Fourth European Conference on Antennas and Propagation, 1. Januar 2010 (2010-01-01), Seiten 1-5, XP055177295, ISBN: 978-1-42-446431-9, ist es bekannt, eine breitbandige Anpassung von Kurzstabantennen auf der Basis von sogenannten Matching-Kreisen vorzunehmen, wobei diesbezüglich Kompensationsschaltungen zum Einsatz kommen, welche einen LC-Parallelresonanzkreis enthalten.

Aus dem Vorgenannten ist es Aufgabe der Erfindung, eine weiterentwickelte Kurzstab-Monopolantenne für den Einsatz im mobilen Bereich, insbesondere im Kraftfahrzeugbereich oder für den Einsatz auf Booten oder dergleichen anzugeben, welche ohne mechanische Abstimmmittel, z.B. durch Längenveränderung des Strahlers in der Lage ist, eine maximale Bandbreite mit maximalem Wirkungsgrad bereitzustellen.

Die Lösung der Aufgabe der Erfindung erfolgt durch die Lehre gemäß der Merkmalskombination nach Anspruch 1. Es wird demnach von einer gewickelten Kurzstab-Monopolantenne für den Einsatz im mobilen Bereich ausgegangen, welche aus einem Strahler, einem Antennenfuß und einem Antennengehäuse besteht. Im Antennengehäuse befinden sich elektrische und/oder elektronische Komponenten. Weiterhin ist am Antennengehäuse oder am Antennenfuß ein Antennenausgang vorgesehen.

Es ist eine Kompensationsschaltung ausgebildet, welche am Fußpunkt des Strahlers angeschlossen ist. Der Strahler stellt sich elektrisch als Reihenschaltung eines Serienresonanzkreises und eines Widerstands dar. Die Kompensationsschaltung ist als Parallelresonanzkreis aus einem Kondensator C_{K} und einer Induktivität L_{K} gebildet.

Weiterhin ist die Länge des Strahlers auf im Wesentlichen eine Resonanzfrequenz in der Mitte des betreffenden Betriebsfrequenzbands abgestimmt, wobei die Kompensationsschaltung den negativen Blindwiderstand des Strahlers unterhalb der Resonanzfrequenz und den positiven Blindwiderstand des Strahlers oberhalb der Resonanzfrequenz durch Parallelschaltung kompensiert mit der Folge der gewünschten Bandbreitenvergrößerung.

Resonanzfrequenzseitig hat der Strahler einen rein ohmschen Widerstand. Unterhalb der Resonanzfrequenz besitzt der Strahler einen negativen Blindwiderstand und oberhalb der Resonanzfrequenz einen positiven Blindwiderstand.

Wenn nun die Impedanz der Kompensationsschaltung so ausgelegt ist, dass diese unterhalb der Resonanzfrequenz einen positiven Blindwiderstand und oberhalb der Resonanzfrequenz einen negativen Blindwiderstand besitzt, dann heben sich durch Parallelschaltung die Blindwiderstände des Strahlers und der Kompensationsschaltung auf und es findet die Bandbreitenerhöhung der Antenne bei gleichzeitigem verbesserten Wirkungsgrad statt.

Ausgestaltend liegt der Blindwiderstand des Kondensators C_{K} bei einer Resonanzfrequenz des Strahlers im Bereich zwischen im Wesentlichen 5 bis 20 Ohm.

Die Kurzstab-Monopolantenne ist als CB-Antenne für die Kanäle 1 bis 80 im Frequenzbereich von 26,565 bis 27,405 MHz ausgebildet, wobei der Strahler eine feste, unveränderbare Länge aufweist.

Eine weitere Verbesserung der Bandbreite gelingt erfindungsgemäß durch einen an die Kompensationsschaltung angeschlossenen Koppelkondensator C₁, dessen Blindwiderstand bei der Resonanzfrequenz des Strahlers zwischen im wesentlichen 30 bis 50 Ohm liegt.

Die Antennenimpedanz liegt bei 50 Ohm.

Die Erfindung soll nachstehend anhand eines Ausführungsbeispiels sowie unter Zuhilfenahme von Figuren näher erläutert werden.

Hierbei zeigen:
- Fig. 1: eine Prinzipdarstellung einer Kurzstab-Monopolantenne für den Einsatz im mobilen Bereich, umfassend Antennenfuß, Antennengehäuse und Antennenausgang;
- Fig. 2a und 2b: eine Prinzipdarstellung einer gewickelten Kurzstab-Monopol-antenne nebst elektrischem Ersatzschaltbild;
- Fig. 3: eine Prinzipdarstellung des Ersatzschaltbilds einer Kurzstab-Monopolantenne mit erfindungsgemäßem Parallelresonanz-kreis, umfassend Kondensator C_{K} und Induktivität L_{K} mit einer Antennenimpedanz R_{L} = 50 Ohm;
- Fig. 4: das Stehwellenverhältnis (VSWR) einer gewickelten Kurzstabantenne ohne Kompensationsschaltung (gestrichelte Linie) und derselben Antenne mit Kompensationsschaltung (durchgehende Linie);
- Fig. 5: ein Ersatzschaltbild einer gewickelten Kurzstabantenne nebst Kompensationsschaltung aus parallel geschalteter Induktivität L_{K} und Kondensator C_{K} mit der Reihenschaltung eines zusätzlichen Koppelkondensators C₁;
- Fig. 6: ein Diagramm eines Stehwellenverhältnisses (VSWR) einer gewickelten Kurzstabantenne ohne Kompensationsschaltung (gestrichelte Linie) und derselben Antenne mit Kompensationsschaltung und zusätzlichen Koppelkondensator C₁ (durchgehende Linie) und

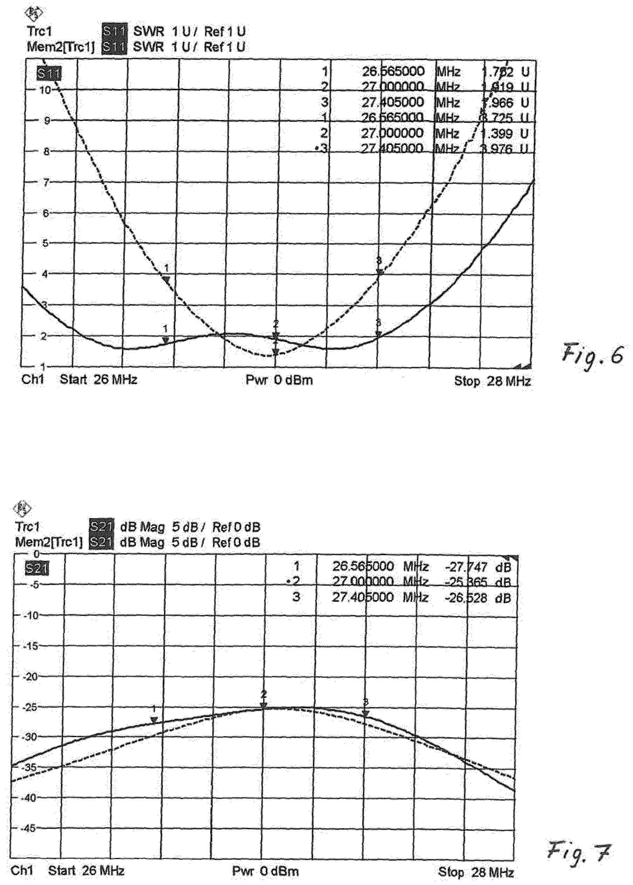

- Fig. 7: ein Diagramm eines Ergebnisses von Vergleichsmessungen der Übertragungsparameter bzw. Sendeparameter einer gewickelten Kurzstabantenne ohne Kompensationsschaltung (gestrichelte Linie) und derselben Antenne mit Kompensationsschaltung und Koppelkondensator C₁ (durchgehende Linie), wobei auf der Resonanzfrequenz (Marker 2) der Kurzstabantenne ohne Kompensationsschaltung die Sendeparameter vergleichbar sind, hingegen bei den Grenzbereichsfrequenzen (Marker 1 und 3) deutlich ist, dass die Antenne mit Kompensationsschaltung und Koppelkondensator ein Gewinn von bis zu 4 dB im Vergleich zu einer Antenne ohne Kompensationsschaltung aufweist.

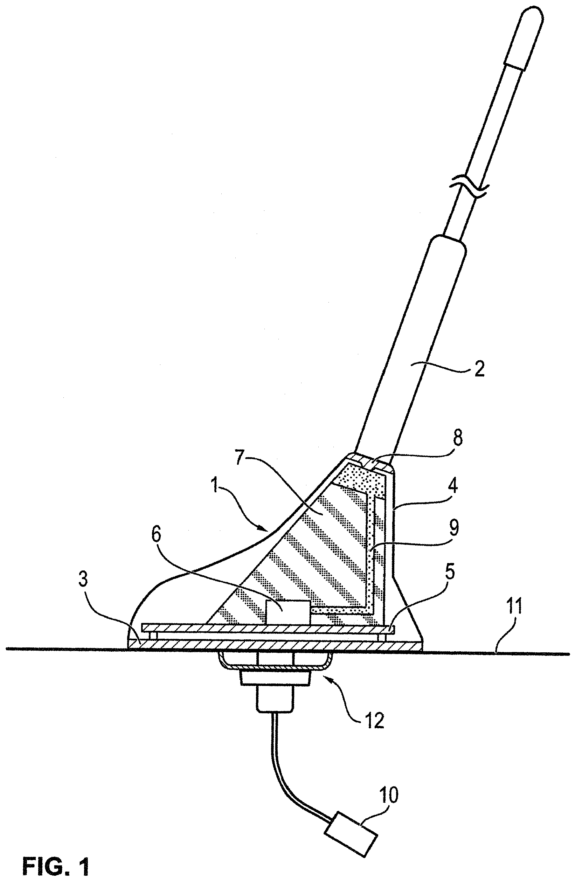

Die beispielhafte Kurzstab-Monopolantenne 1 nach Fig. 1 besteht aus einem Strahler 2, einem Antennenfuß 3 und einem Antennengehäuse 4 bzw. einer entsprechenden Kapselung.

Auf dem Antennenfuß 3, von der Abdeckung 4 umgeben, befindet sich eine Grundleiterplatte 5, welche notwendige elektrische oder elektronische Komponenten (nicht gezeigt) aufnimmt. Darüber hinaus befindet sich auf der Grundleiterplatte 5 eine Anpassungsschaltung 6.

Im Wesentlichen senkrecht von der Grundleiterplatte 5 erstreckt sich eine Verbindungsleiterplatte 7.

Im oberen Teil des Antennengehäuses 4 bzw. der Abdeckung ist ein Kontaktelement 8 zur Aufnahme des unteren Endes des Strahlers 2 befindlich. Der Strahler 2 kann z.B. über ein Gewindeende verfügen und an dem Verbindungselement 8 durch Einschrauben fixiert werden.

Die Verbindungsleiterplatte 7, die sich im Wesentlichen senkrecht zur Grundleiterplatte 5 erstreckt, approximiert die Längsschnittfläche unterhalb des Gehäuses 4 und weist eine kupferkaschierte Anschlussflächenstruktur 9 auf. Die Oberseite bzw. das obere Ende der Anschlussflächenstruktur 9 steht mit dem Verbindungselement 8 in elektrischem Kontakt und hierüber in elektrischer Verbindung zum Strahler 2. Der Antennenausgang 10 kann entweder als Kabelantennenausgang mit kundenspezifischer Stecker- oder Buchsenkonfiguration oder als im Antennenfuß integrierten FAKRA-Stecker oder ähnlich ausgebildet werden.

Im gezeigten Beispiel nach Fig. 1 ist die Antenne 1 mittels geeigneter Befestigungseinrichtungen 12 auf einem Fahrzeugdach 11 montiert.

Üblicherweise ist der Strahler 2 auf eine Resonanzfrequenz in der Mitte des jeweiligen Betriebsfrequenzbereichs, z.B. 26,985 MHz für den CB-Frequenzbereich 26,565 bis 27,405 MHz oder 97,5 MHz für den UKW-Hörfunkbereich 87 MHz bis 108 MHz abgestimmt.

Die Länge des Strahlers 2 bzw. die Bauhöhe der gesamten Antenne 1 für Fahrzeuganwendungen ist von besonderer Bedeutung. Personenkraftwagen besitzen bei zu großer Antennenhöhe Probleme beim Einfahren in Parkgaragen. Bei Nutzkraftwagen darf die Antenne eine gesetzlich vorgeschriebene Gesamthöhe des Fahrzeugs nicht überschreiten. Aus vorstehend genannten Gründen sind die Längen von Stabstrahlern für den Hörfunkbereich auf maximal 40 cm begrenzt. Die Längen von Stabstrahlern für Nutzkraftwagen betragen im Hörfunkbereich ebenfalls maximal 40 cm bzw. im Bereich des CB-Funks maximal 50 cm.

Die auf die Freiraumwellenlängen der Betriebsfrequenzen bezogene Länge des Stabes beträgt für den CB-Funk 0,04 und für den UKW-Hörrundfunkbereich 0,13, d.h. unter Berücksichtigung des Voranstehenden ist der Stab, d.h. der Strahler eine elektrisch gesehen kurze Antenne.

Die Strahlerbandbreite einer elektrisch kurzen Antenne ist in etwa proportional der dritten Potenz der elektrischen Länge der Antenne und daher sehr schmal.

Daher wird gemäß dem Stand der Technik bei CB-Antennen ein Abstimmmittel vorgesehen, um eine Feinabstimmung auf den jeweiligen Betriebskanal vorzunehmen. Dies ist nur dann praktikabel, wenn die Betriebskanäle nicht häufig geändert werden. Als Abstimmmittel ist z.B. eine Teleskopanordnung, ein Abstimmstub, ein entlang des Strahlers verschiebbares Rohr oder dergleichen denkbar.

Mit der vorgestellten Lösung gelingt es, eine Kurzstabantenne zu schaffen, die einerseits bei kleiner Länge andererseits eine möglichst große Bandbreite liefert sowie eine besonders kostengünstige Herstellung und zeitsparende Montage sowie Inbetriebnahme ermöglicht.

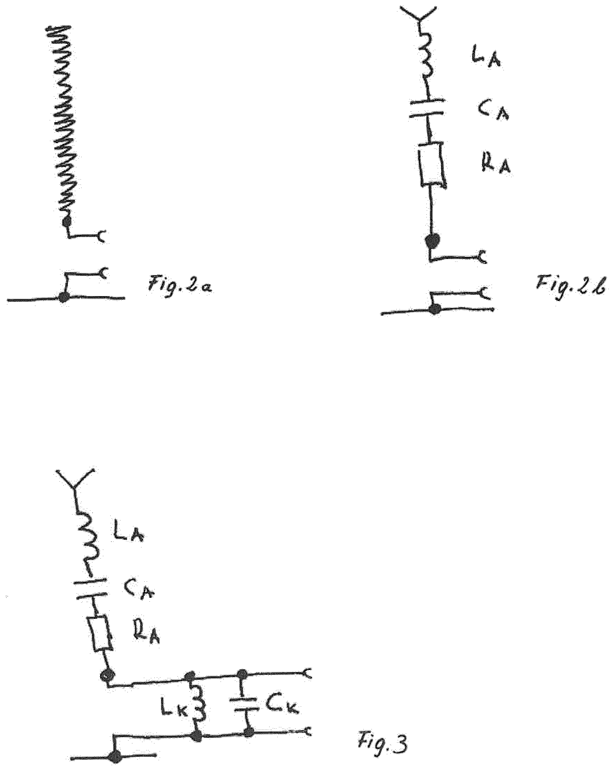

Wie aus der Fig. 2b ersichtlich, kann in elektrischer Hinsicht ein Monopol-Stabstrahler bzw. eine Kurzstab-Monopolantenne durch eine Reihenschaltung eines Serienresonanzkreises mit einem ohmschen Widerstand beschrieben werden. Der Serienresonanzkreis umfasst die Induktivität L_{A} und die Kapazität C_{A}. Der ohmsche Widerstand der gewickelten Kurzstabantenne ist gemäß Fig. 2b mit R_{A} bezeichnet.

Bei Resonanzfrequenz weist der Strahler einen rein ohmschen Widerstand auf. Unterhalb der Resonanzfrequenz besitzt der Strahler einen negativen Blindwiderstand, oberhalb der Resonanzfrequenz einen positiven Blindwiderstand.

Wenn eine Kompensationsschaltung 6 so ausgeführt ist, dass diese geänderte Verhältnisse besitzt, ist eine Kompensation der Blindwiderstände möglich. Diesbezüglich muss die Anpassungsschaltung unterhalb der Resonanzfrequenz einen positiven Blindwiderstand und oberhalb der Resonanzfrequenz einen negativen Blindwiderstand besitzen. Erfolgt dann eine Parallelschaltung, wie in der Fig. 3 gezeigt, kompensieren sich die Blindwiderstände von Strahler bzw. Antenne und Anpassungsschaltung, so dass sich die Bandbreite der Antenne erhöht.

Zur Realisierung der genannten Verhältnisse umfasst die Kompensationsschaltung, als Parallelresonanzkreis ausgebildet, einen Kondensator C_{K} und eine Induktivität L_{K}.

Der Blindwiderstand des Kondensators C_{K} der Kompensationsschaltung bei der Resonanzfrequenz weist im Wesentlichen 5 bis 20 Ohm auf. Das Maß der Induktivität muss die Resonanzfrequenz gewährleisten und andererseits minimale Verluste sicherstellen, um die gewünschte Bandbreitenerhöhung sowie einen maximalen Wirkungsgrad der Antenne zu erhalten.

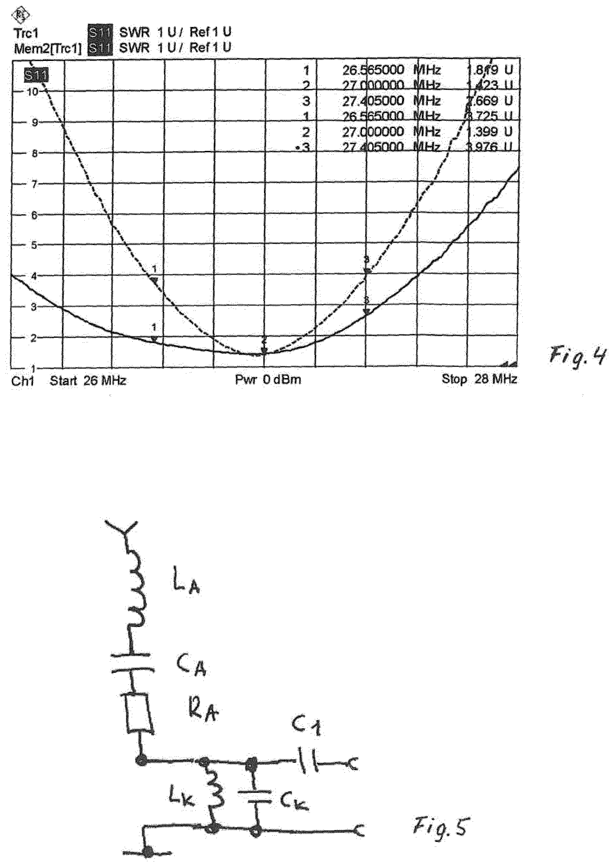

Eine weitere Verbesserung der Wirkung der Kompensationsschaltung ergibt sich bei einer Lösung wie in der Fig. 5 dargestellt. Ausgehend vom Ersatzschaltbild einer gewickelten Kurzstabantenne, umfassend eine Reihenschaltung aus Induktivität L_{A}, Kapazität C_{A} und dem Widerstand der gewickelten Kurzstabantenne RA ist ein Parallelresonanzkreis als Kompensationsschaltung, umfassend die Induktivität L_{K} und die Kapazität C_{K} vorgesehen. An dieser Parallelschaltung L_{K/}C_{K} ist ein Koppelkondensator C₁ angeschlossen, welcher die Bandbreite verbessert. Der Blindwiderstand des Koppelkondensators C₁ liegt bei der Resonanzfrequenz des Strahlers im Bereich zwischen den im Wesentlichen 30 bis 50 Ohm.

Die Messergebnisse gemäß den Figuren 4, 6 und 7 zeigen die erfindungsgemäße Wirkung und ihre Vorteile deutlich auf.

Gemäß dem Diagramm VSWR einer gewickelten Kurzstabantenne nach Figur 4 mit und ohne Kompensationsschaltung ist ersichtlich, dass durch die erfindungsgemäße Kompensation sich die Bandbreite der Kurzstabantenne wirksam vergrößert (durchgehende Linie).

Figur 6 zeigt das Stehlwellenverhältnis einer gewickelten Kurzstabantenne ohne Kompensationsschaltung (gestrichelte Linie) und derselben Antenne mit Kompensationsschaltung und zusätzlichen Koppelkondensator C₁ (durchgehende Linie). Der Einsatz des Koppelkondensators C1 vergrößert die Bandbreite im Vergleich zur Darstellung nach Figur 4 nochmals.

Figur 7 ist das Ergebnis von Vergleichsmessungen der Übertragungs- bzw. Sendeparameter einer gewickelten Kurzstabantenne ohne Kompensationsschaltung (gestrichelte Linie) und derselben Antenne mit Kompensationsschaltung und Koppelkondensator (durchgehende Linie). Insbesondere im Bereich der Grenzfrequenzen (Marker 1 und Marker 3) zeigt die Antenne mit Kompensationsschaltung und Koppelkondensator einen Gewinn von bis zu 4 dB im Vergleich zur nicht erfindungsgemäß ausgebildeten Antenne.

## Patentansprüche

1. Gewickelte Kurzstab-Monopolantenne (1), ausgebildet als CB-Antenne für den Frequenzbereich von 26,565 - 27,405 MHz für den Einsatz im mobilen Bereich, bestehend aus einem Strahler (2), einem Antennenfuß (3), einem Antennengehäuse (4), welches dazu ausgebildet ist, elektrische und/oder elektronische Komponenten (5; 7; 9) aufzunehmen, sowie einem am Antennengehäuse oder Antennenfuß vorgesehenen Antennenausgang (10),
wobei eine Kompensationsschaltung (6) vorgesehen ist, welche am Fußpunkt des ohne mechanische Abstimmmittel ausgebildeten Strahlers (2) mit fester, unveränderbarer Länge angeschlossen ist, wobei die Kompensationsschaltung (6) als Parallelresonanzkreis aus einem Kondensator (C_{K}) und einer Induktivität (L_{K}) gebildet ist und an der Kompensationsschaltung ein Koppelkondensator C₁ angeschlossen ist,
die Länge des Strahlers (2) auf die Resonanzfrequenz in der Mitte des Betriebsfrequenzbands abgestimmt ist, wobei die Kompensationsschaltung (6) den negativen Blindwiderstand des Strahlers (2) unterhalb der Resonanzfrequenz und den positiven Blindwiderstand des Strahlers oberhalb der Resonanzfrequenz durch Parallelschaltung kompensiert mit der Folge einer Bandbreitenvergrößerung, weiterhin der Blindwiderstand des Kondensators (C_{K}) bei der Resonanzfrequenz des Strahlers (2) im Bereich zwischen im Wesentlichen 5 bis 20 Ohm und der Blindwiderstand des Koppelkondensators (C₁) bei der Resonanzfrequenz des Strahlers (2) im Bereich zwischen im Wesentlichen 30 bis 50 Ohm liegt, so dass
die Antennenimpedanz 50 Ohm beträgt.

## Claims

1. A wound short rod monopole antenna (1) configured as a CB antenna for the frequency range from 26.565 to 27.405 MHz for being used in a mobile environment, composed of an emitter (2), an antenna base (3), an antenna housing (4) configured to receive electrical and/or electronic components (5; 7; 9), and an antenna outlet (10) provided at the antenna housing or the antenna base,
wherein a compensation circuitry (6) is provided which is connected to the base point of the emitter (2) configured without mechanical tuning means and has a fixed, invariable length, wherein the compensation circuitry (6) is formed as a parallel resonance circuit made up of a capacitor (C_{K}) and an inductance (L_{K}), and a coupling capacitor (C₁) is connected to the compensation circuitry,
the length of the emitter (2) is matched to the resonance frequency in the center of the operation frequency band, wherein the compensation circuitry (6) compensates the negative reactance of the emitter (2) below the resonance frequency and the positive reactance of the emitter above the resonance frequency by parallel connection with the consequence of a band width enlargement, moreover the reactance of the capacitor (C_{K}) at a resonance frequency of the emitter (2) being in the range between substantially 5 to 20 Ohms, and the reactance of the coupling capacitor (C₁) at the resonance frequency of the emitter (2) being in the range between substantially 30 to 50 Ohms, so that the antenna impedance amounts to 50 Ohms.

## Revendications

1. Antenne monopole à tige courte enroulée (1), réalisée sous forme d'antenne CB pour la gamme de fréquences de 26,565 - 27,405 MHz pour une utilisation dans le secteur mobile, constituée d'un élément rayonnant (2), d'une base d'antenne (3), d'un boîtier d'antenne (4) réalisé pour recevoir des composants électriques et/ou électroniques (5 ; 7 ; 9), et d'une sortie d'antenne (10) prévue sur le boîtier d'antenne ou sur la base d'antenne,
dans laquelle
il est prévu un circuit de compensation (6) qui est relié au point de base de l'élément rayonnant (2), dépourvu de moyens d'accord mécaniques, avec une longueur fixe, non modifiable, le circuit de compensation (6) étant formé comme un circuit résonnant parallèle à partir d'un condensateur (C_{K}) et d'une inductance (L_{K}), et un condensateur de couplage C₁ étant relié au circuit de compensation,
la longueur de l'élément rayonnant (2) est accordée sur la fréquence de résonance au milieu de la bande de fréquences de fonctionnement,
le circuit de compensation (6) compense la réactance négative de l'élément rayonnant (2) au-dessous de la fréquence de résonance et la réactance positive de l'élément rayonnant au-dessus de la fréquence de résonance par une connexion parallèle avec pour résultat une augmentation de la largeur de bande,
en outre, la réactance du condensateur (C_{K}) à la fréquence de résonance de l'élément rayonnant (2) est dans la gamme entre sensiblement 5 à 20 ohms et la réactance du condensateur de couplage (C₁) à la fréquence de résonance de l'élément rayonnant (2) est dans la gamme entre sensiblement 30 à 50 ohms, de sorte que l'impédance de l'antenne est de 50 ohms.
